# EUROPEAN PATENT APPLICATION

(11) **EP 4 258 546 A1**
(43) Date of publication of application: **11.10.2023**
(21) Application number: 23166017.6
(22) Date of filing: 31.03.2023
(51) Int. Cl.: H03F 3/45, G05F 3/26

(54) **DEVICE FOR COPYING A CURRENT**

(30) Priority: 06.04.2022 FR 2203131
(71) Applicant: STMICROELECTRONICS (GRENOBLE 2) SAS, 38000 Grenoble (FR); STMicroelectronics (ALPS) SAS, 38000 Grenoble (FR)
(72) Inventor: MICHAL, Vratislav, 38120 LE FONTANIL-CORNILLON (FR)
(74) Representative: Cabinet Beaumont

(57) **Abstract**

The present disclosure relates to a device (1041; 1061) comprising an input node (1041i; 1061i) receiving a first current (11; 12), an output node (1041o; 1061o) providing a second current (13; 14), a first resistor (RA) connected between the input node and a first node (108) receiving a supply voltage (VSS), a MOS transistor (M2) having a source connected to the first node (108) and a drain coupled to the output node (1041o; 1061o), a second resistor (RS) having a first terminal connected to a gate of the MOS transistor (M2), a biasing circuit (200) providing a biasing voltage on a second terminal of the second resistor (RS), and a capacitor (C) connected between the input node (1041i; 1061i) and the gate of the MOS transistor (M2).

## Description

### Technical field

The present disclosure relates generally to electronics circuits and electronic devices, and, more particularly, to electronics circuits and devices for copying a current.

### Background art

Devices for copying a current, such as current mirrors implemented with MOS transistors ("Metal Oxide Semiconductor" transistors), are known. These known devices receive an input current on an input node and provide an output current on an output node, such that the output current is an image of the input current. Said in other words, the output current is determined by the input current. For example, the output current is proportional, for example equal, to the input current.

In these known devices, a modification in the value of the input current results in a corresponding modification in the value of the output current.

### Summary of Invention

There is a need for addressing all or some of the drawbacks of known devices for copying a current.

For example, in known devices for copying a current, when the output current is used for charging or discharging a capacitive element, when a modification in the value of the input current occurs, a corresponding modification in the value of the output current may be delayed with respect to the modification in the value of the input current. It would be preferable, for example, to reduce the delay between the modification of the input current and the corresponding modification of the output current.

One embodiment addresses all or some of the drawbacks of known devices for copying a current.

One embodiment provides a device comprising:
an input node configured to receive a first current;
an output node configured to provide a second current determined by the first current;
a first resistor having a first terminal connected to the input node and a second terminal coupled to a first node configured to receive a first supply voltage;
a first MOS transistor having a source connected to the first node and a drain coupled to the output node of the device;
a second resistor having a first terminal connected to a gate of the first MOS transistor;
a biasing circuit configured to provide a biasing voltage on a second terminal of the second resistor; and
a first capacitor connected between the input node and the gate of the first MOS transistor.

According to one embodiment, the drain of the first transistor is connected to the output node.

According to one embodiment, the device further comprises a second MOS transistor having a channel of the same type as the channel of the first MOS transistor, the second MOS transistor coupling the drain of the first MOS transistor to the output node and being series-connected with the first MOS transistor.

According to one embodiment, the biasing circuit comprises a third MOS transistor having a channel of the same type as the channel of the first MOS transistor, the third MOS transistor having a drain and a gate connected with each other, and a source connected to the first node, the gate of the third MOS transistor being connected to the second terminal of the second resistor.

According to one embodiment, the third MOS transistor is series-connected with the first resistor.

According to one embodiment, the third MOS transistor has its drain connected to the second terminal of the first resistor.

According to one embodiment, the bias circuit further comprises a current source series-connected with the third MOS transistor.

According to one embodiment, the second terminal of the first resistor is connected to the first node.

According to one embodiment, the bias circuit further comprises a second capacitor connected between the gate of the third MOS transistor and the first node.

One embodiment provides an amplifier, for example a transconductance amplifier, comprising:
a first device as previously described;
a second device as previously described, the output node of the second device being coupled, preferably connected, to an output node of the amplifier;
a differential pair comprising:
   - a first MOS transistor having a first conduction node coupled, preferably connected, to the input node of the first device, and a gate connected to a first input of the amplifier, and
   - a second MOS transistor having a channel of the same type as the channel of the first MOS transistor of the differential pair, a first conduction node coupled, preferably connected, to the input node of the second device, and a gate connected to a second input of the amplifier; and
a current source for biasing the differential pair, the current source having a terminal coupled, preferably connected, to a second conduction terminal of each of the first and second MOS transistors of the differential pair and another terminal coupled, preferably connected, to a node configured to receive a second supply potential.

One embodiment provides an amplifier comprising:
a first device as previously described;
a second device as previously described, the output node of the second device being coupled, preferably connected, to an output node of the amplifier;
a differential pair comprising:
   - a first MOS transistor having a first conduction node coupled, preferably connected, to the input node of the first device, and a gate connected to a first input of the amplifier, and
   - a second MOS transistor having a channel of the same type as the channel of the first MOS transistor of the differential pair, a first conduction node coupled, preferably connected, to the input node of the second device, and a gate connected to a second input of the amplifier; and
a current source for biasing the differential pair, the current source having a terminal coupled, preferably connected, to a second conduction terminal of each of the first and second MOS transistors of the differential pair and another terminal coupled, preferably connected, to a node configured to receive a second supply potential.

According to one embodiment, the amplifier further comprises a supplementary amplifier, for example a supplementary transconductance amplifier, having a first input coupled, preferably connected, to the gate of the first MOS transistor of the differential pair, a second input coupled, preferably connected, to the gate of the second transistor of the differential pair, and an output coupled, preferably connected, to the output node of the amplifier.

According to one embodiment, the biasing circuit of the first device is also the biasing circuit of the second device.

According to one embodiment, the amplifier further comprises a first circuit coupled to the output node of the first device, the output node of the amplifier and the node configured to receive the second supply potential, wherein the first circuit is configured to receive the second current of the first device and to provide a current proportional to this second current to the output node of the amplifier.

According to one embodiment, the amplifier is adapted to implement a transimpedance function between its inputs and its output node.

### Brief description of drawings

The foregoing features and advantages, as well as others, will be described in detail in the following description of specific embodiments given by way of illustration and not limitation with reference to the accompanying drawings, in which:
Figure 1 illustrates a circuit of an example of a transconductance amplifier comprising known devices for copying a current;
Figure 2 illustrates a circuit of a transconductance amplifier comprising devices for copying a current according to one embodiment;
Figure 3 illustrates with waveforms an operation of the amplifier of Figure 2 according to one embodiment;
Figure 4 illustrates an alternative embodiment of a device for copying a current;
Figure 5 illustrates another alternative embodiment of a device for copying a current; and
Figure 6 illustrates a circuit of a transconductance amplifier similar to the one of Figure 2 comprising devices for copying a current according to yet another alternative embodiment.

### Description of embodiments

Like features have been designated by like references in the various figures. In particular, the structural and/or functional features that are common among the various embodiments may have the same references and may dispose identical structural, dimensional and material properties.

For the sake of clarity, only the operations and elements that are useful for an understanding of the embodiments described herein have been illustrated and described in detail. In particular, the known circuits comprising a device for copying a current have not been described in detail, the described embodiments being compatible with these known circuits.

Unless indicated otherwise, when reference is made to two elements connected together, this signifies a direct connection without any intermediate elements other than conductors, and when reference is made to two elements coupled together, this signifies that these two elements can be connected or they can be coupled via one or more other elements.

In the following disclosure, unless indicated otherwise, when reference is made to absolute positional qualifiers, such as the terms "front", "back", "top", "bottom", "left", "right", etc., or to relative positional qualifiers, such as the terms "above", "below", "higher", "lower", etc., or to qualifiers of orientation, such as "horizontal", "vertical", etc., reference is made to the orientation shown in the figures.

Unless specified otherwise, the expressions "around", "approximately", *"*substantially*"* and "in the order of" signify within 10 %, and preferably within 5 %.

In the following description, unless specified otherwise, when reference is made to the gate of a MOS transistor, this signify the front gate of the MOS transistor.

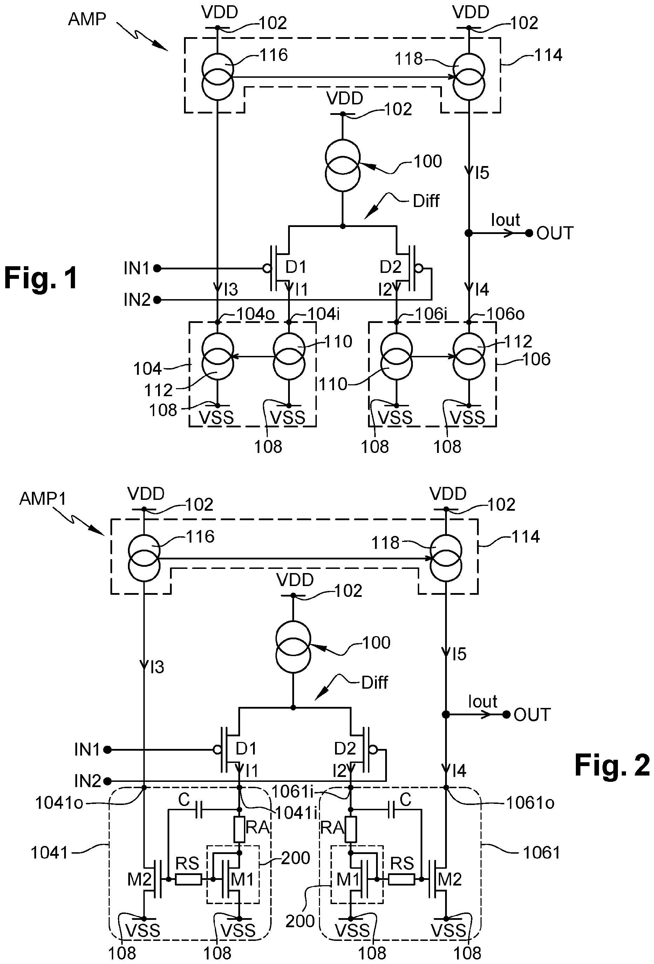

Figure 1 illustrates a circuit of an example of a transconductance amplifier AMP comprising known devices for copying a current.

The amplifier AMP comprises an input node IN1, an input node IN2 and an output node OUT. The amplifier AMP is configured to provide, on its output node OUT, a current Iout representative of a voltage difference between its nodes IN1 and IN2.

The amplifier AMP comprises a differential pair Diff. The differential pair Diff comprises a MOS transistor D1 and a MOS transistor D2. The transistor D1 has a gate connected to the input node IN1. The transistor D2 has a gate connected to the input node IN2.

The amplifier AMP comprises a current source 100. The current source 100 couples a node 102 configured to receive a supply voltage VDD to a conduction terminal of each of the transistors D1 and D2. The current source 100 is configured to bias the differential pair Diff, and, more particularly, to bias the transistors D1 and D2.

The amplifier AMP comprises a device 104 for copying a current and a device 106 for copying a current. Preferably, device 104 is identical to device 106.

Device 104, respectively 106, has an input node 104i, respectively 106i, coupled, preferably connected, to a conduction terminal of transistor D1, respectively D2, the other conduction terminal of transistor D1, respectively D2, being coupled, preferably connected, to the current source 100. Node 104i is configured to receive an input current I1 from the differential pair Diff, node 106i being configured to receive an input current I2 from the differential pair. Device 104, respectively 106, has an output node 104o, respectively 106o, configured to provide an output current 13, respectively 14. Current I3, respectively I4, is determined by current I1, respectively I2. Device 104, respectively 106, couples the differential pair Diff, for example the transistor D1, respectively D2, to a node 108 configured to receive a supply voltage VSS.

More generally, the differential pair Diff comprises a first branch controlled by the input node IN1 which couples the current source 100 to device 104 and provides the current I1 to device 104, and a second branch controlled by the input node IN2 which couples the current source 100 to the device 106 and provides the current I2 to the device 106.

Device 104, respectively 106, has its input node 104i, respectively 106i, coupled, preferably connected, to a conduction terminal of transistor D1, respectively D2, the other conduction terminal of transistor D1, respectively D2, being coupled, preferably connected, to the current source 100. Node 104i is configured to receive an input current I1 from the differential pair Diff, node 106i being configured to receive an input current I2 from the differential pair Diff.

In the example of Figure 1, the supply voltage VDD is higher than the supply voltage VSS, voltage VSS being for example the ground. In such an example, transistors D1 and D2 are, for example, PMOS transistors, or, said in other words, MOS transistors with a P-type channel. Transistors D1 and D2 thus have their respective sources coupled, preferably connected, to the current source 100, and their respective drains coupled, for example connected, to respective nodes 104i and 106i.

In the example of Figure 1, devices 104 and 106 are current controlled current sources, CCCS, for example current mirrors, schematically represented by a first current source 110 receiving the input current of the device and by a second current source 112 controlled by the first current source 100 and providing the output current of the device. For example, the current source 110 of device 104, respectively 106, couples the node 104i, respectively 106i, to the node 108, the current source 112 of device 104, respectively 106, coupling the node 108 to the node 104o, respectively 106o. For example, current source 112 of device 104, respectively 106, is configured to deliver the current I3, respectively 14, having a value controlled by the value of the current I1, respectively I2, flowing across the current source 100 of device 104, respectively 106.

The output node 106o of device 106 is coupled, preferably connected, to the output node OUT of the amplifier AMP. In other words, the node 106o is coupled to node OUT such that current I4 is provided to node OUT.

The output node 104o of device 104 is coupled to the output node OUT of the amplifier AMP. In other words, the node 104o is coupled to node OUT such that a current I5 determined by the current I3 is provided to node OUT. Current I5 is for example proportional, preferably equal, to current I3.

Thus, the current Iout is determined by a difference between currents I5 and I4. Current Iout is provided to a load (not represented) connected to the output node OUT, for example a load comprising a capacitive element coupling node OUT to node 108.

The amplifier AMP comprises a circuit 114 coupling the node 104o to the node OUT. The circuit 114 is configured to receive current I3 from the device 104 and to provide current I5 to node OUT, the current I5 being determined by current I3. More particularly, circuit 114 is coupled to nodes 104o, 102 and OUT.

In the example of Figure 1, device 114 is a current mirror schematically represented by a first current source 116 having the current I3 flowing across its terminals and by a second current source 118 controlled by the current source 116, thus by current I3, and providing the current I5 to the node OUT. For example, the current source 116 couples the node 104o to the node 102, the current source 118 coupling the node 102 to the node OUT.

In the amplifier AMP, when a voltage step is applied between the inputs IN1 and IN2, a corresponding modification in the voltage on the output node OUT has a slew rate which is limited by the capacitance value of the node OUT and the value of the transconductance gain gm between the voltage across the nodes IN1 and IN2 and the current Iout. Further, the bandwidth of the amplifier AMP is also limited by the capacitance value of the node OUT and the value of the transconductance gain gm.

In devices 104 and 106, current I3, respectively I4, is equal to K*I1, respectively K*I2, K being a proportionality coefficient. The slew rate and the bandwidth of the amplifier AMP may be increased by increasing the value of coefficient K. However, this increases the surface occupied by the devices 104 and 106 and the power consumption of the amplifier AMP.

The present disclosure provides a device for copying a current in which a modification in the input current of the device leads to a corresponding modification in the output current of the device which is faster than in a known current mirror receiving the same modification in its input current and having transistors with sizes similar or identical to the sizes of the transistor of the provided device.

To achieve this goal, the disclosed device for copying a current comprises a first resistor having a terminal connected to the input node of the disclosed device and another terminal coupled to a first node configured for receiving a supply voltage. The output current of the disclosed device is flowing across a MOS transistor, referenced M2 in the following disclosure. Transistor M2 has a source connected to the first node, a drain coupled, for example connected, to the output node of the disclosed device, and a gate coupled to the input node of the disclosed device by a capacitor. The disclosed device further comprises a biasing circuit providing a biasing voltage to a second node coupled to the gate of the MOS transistor M2 by second resistor. The capacitor coupling the input node of the disclosed device to the gate of the MOS transistor M2 is preferably different from an intrinsic or parasitic capacitance.

Thus, when a modification of the current received by the input node of the disclosed device occurs, for example a transient event corresponding to an increase or a decrease of the value of the input current, this current modification is converted by the first resistor into a corresponding voltage modification on the input node of the disclosed device, and is transmitted on the gate of the transistor M2 by the capacitor, thus resulting in a corresponding modification of the current across the MOS transistor M2. The voltage across the second resistor is not null during the modification of the input and output currents, or, said otherwise, during the transient event, and is null in a steady state where the input and output currents of the device are constant.

Figure 2 illustrates a circuit of a transconductance amplifier AMP1 comprising devices for copying a current according to one embodiment.

The amplifier AMP1 is similar to the amplifier AMP, and only the differences between these two amplifiers will be described in detail.

More particularly, the amplifier AMP1 differs from the amplifier AMP by the fact that device 104, respectively 106, of amplifier AMP is replaced by a device 1041, respectively 1061, for copying a current. Preferably, devices 1041 and 1061 are identical.

Similarly to device 104, respectively 106, the device 1041, respectively 1061, has an input node 1041i, configured to receive the input current I1, respectively I2, from the differential pair Diff, and an output node 1041o, respectively 1061o, configured to provide the current I3, respectively I4.

Thus, in the amplifier AMP1, node 1041i is connected to the branch of the differential pair Diff controlled by the input IN1, node 1061i is connected to the branch of the differential pair Diff controlled by the input IN2. Further, node 1061o is coupled, preferably connected, to node OUT of the amplifier AMP1, such that current I4 is provided to node OUT. Node 1041o is coupled, preferably connected, to circuit 114 for providing current I3 to circuit 114 which, in turn, provides current I5 to node OUT.

Each of the devices 1041 and 1061 comprises two resistors RA and RS, a capacitor C and a MOS transistor M2.

The source of the transistor M2 of device 1041, respectively 1061, is connected to node 108. The drain of the transistor M2 of device 1041, respectively 1061, is coupled to the node 1041o, respectively 1061o of the device 1041, respectively 1061.

More particularly, in one embodiment, as illustrated by Figure 2, the drain of the transistor M2 of device 1041, respectively 1061, is connected to the node 1041o, respectively 1061o, of the device 1041, respectively 1061.

In the example of Figure 2, as voltage VDD is higher than voltage VSS, voltages on nodes 1041i and 1041o of device 1041 and voltages on nodes 1061i and 1061o of device 1061 are higher than voltage VSS. Thus, transistor M2 of each device 1041, 1061 is a NMOS transistor, or, said in other words, a MOS transistor having a N-type channel.

The capacitor C of the device 1041, respectively 1061, couples the input node 1041i, respectively 1061i, to the gate of the transistor M2 of the device 1041, respectively 1061. Capacitor C may be implemented using one or a plurality of capacitive components.

The resistor RA of the device 1041, respectively 1061, has a first terminal connected the input node 1041i, respectively 1061i, of the device 1041, respectively 1061. The second terminal of the resistor RA of device 1041, respectively 1061, is coupled to node 108. Resistor RA may be implemented using one or a plurality of resistive components.

The resistor RS of the device 1041, respectively 1061, has a first terminal connected to the gate of transistor M2 of the device 1041, respectively 1061, the second terminal of the resistor RS of device 1041, respectively 1061, being configured to receive a bias voltage from a biasing circuit 200 of the device 1041, respectively 1061. Resistor RS may be implemented using one or a plurality of resistive components.

The biasing circuit 200 of each device 1041 and 1061 comprises a MOS transistor M1 having a channel of the same type than the one of the MOS transistor M2. Transistor M1 of device 1041, respectively 1061, has a gate connected to the resistor RS of the device 1041, respectively 1061, and, more specifically, to the terminal of the resistor RS opposite to the terminal of the resistor RS connected to the gate of transistor M2 of the device 1041, respectively 1061. Further, each transistor M1 has its gate and its drain connected with each other. Said in other words, each transistor M1 is diode-mounted.

In one embodiment, as illustrated by Figure 2, the biasing circuit 200 of the device 1041, respectively 1061, couples the resistor RA of the device 1041, respectively 1061, to the node 108.

More particularly, in the embodiment illustrated by Figure 2, transistor M1 of device 1041, respectively 1061, is series-connected with resistor RA of device 1041, respectively 1061. For example, the interconnected drain and gate of transistor M1 of the device 1041, respectively 1061, is connected to resistor RA, and, more specifically, to the terminal of the resistor RA opposite to the terminal of resistor RA connected to node 1041i, respectively 1061i.

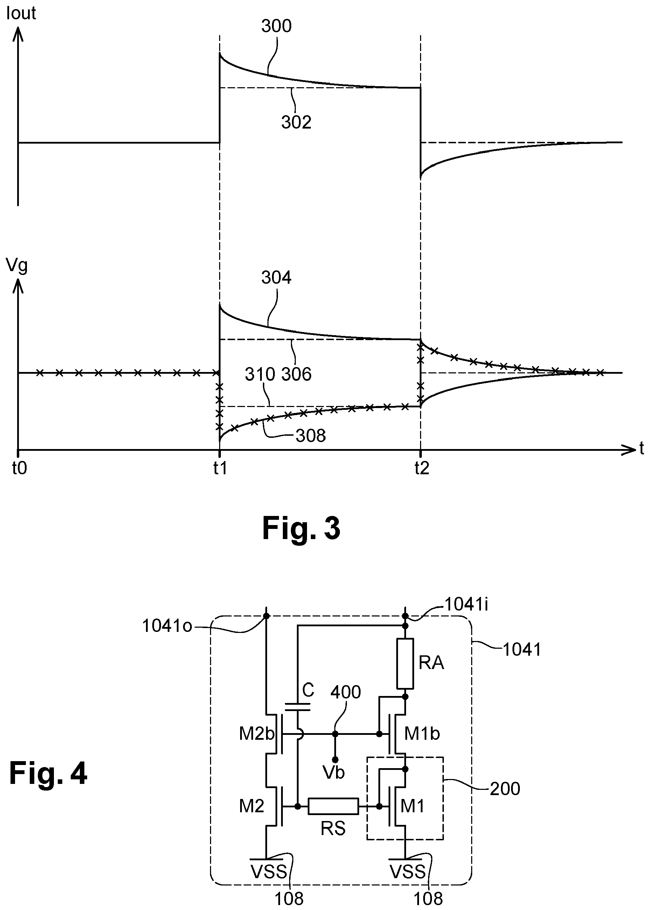

Figure 3 illustrates with waveforms an operation of the amplifier AMP1 of Figure 2 according to one embodiment.

More particularly, in Figure 3:
- a waveform 300 illustrates the variation of the current Iout with time t in the amplifier AMP1;
- a waveform 302 illustrates the variation of the current Iout with time t in the amplifier AMP where devices 104 and 106 are similar to respective devices 1041 and 1061 except that resistors RA, resistors RS and capacitors C are omitted;
- a waveform 304 illustrates the variation, with time t, of the voltage on the gate of transistor M2 of device 1401 of amplifier AMP1;
- a waveform 306 illustrates the variation, with time t, of the voltage on the gate of the transistor M2 of the device 104 of amplifier AMP where device 104 is similar to device 1041 except that resistor RA, resistor RS and capacitor C are omitted;
- a waveform 308 illustrates the variation, with time t, of the voltage on the gate of transistor M2 of device 1601 of amplifier AMP1; and
- a waveform 310 illustrates the variation, with time t, of the voltage on the gate of the transistor M2 of the device 106 of amplifier AMP where device 106 is similar to device 1061 except that resistor RA, resistor RS and capacitor C are omitted.

In Figure 3, between successive instants t0 and t1, the amplifiers AMP and AMP1 are in identical steady states, the voltage between the inputs IN1 and IN2 of each amplifier AMP, AMP1 being constant, and the current Iout of each amplifier AMP, AMP1 being constant and determined by the voltage between inputs IN1 and IN2.

At the instant t1, a voltage step is applied between the inputs IN1 and IN2. In the example of Figure 3, the voltage step corresponds to an increase of the voltage on the input IN2 while the voltage on the input IN1 is not modified. This results in an increase of the current I1 and a decrease of the current I2.

In the amplifier AMP, the increase of current I1 result in an increase of the voltage across transistor M1 of device 104, thus of the voltage on the gate of transistor M2 of this device 104. Conversely, the decrease of current I2 results in a decrease of the voltage across transistor M1 of device 106, thus of the voltage on the gate of transistor M2 of this device 106. It follows that current I3 increases and current I4 decreases, resulting in a step increase of current Iout of amplifier AMP.

The same occurs in the amplifier AMP1, but, because of resistors RA of devices 1041 and 1061, the voltage increase on node 1041i is higher than the voltage increase on node 1041 of amplifier AMP, and the voltage decrease on node 1061i is higher than the voltage decrease on node 106i of the amplifier AMP. Further, as the voltage variations on nodes 1041i and 1061i are transmitted by capacitors C to the gate of transistors M2 of the respective devices 1041 and 1061, the increase of the voltage on the gate of transistor M2 is higher in device 1041 (see curve 304) than in device 104 (see curve 306), and the decrease of the voltage on the gate of transistor M2 is higher in device 1061 (see curve 308) than in device 106 (see curve 310). As a result, the increase of the current Iout is higher in the amplifier AMP1 (see curve 300) than in the amplifier AMP (see curve 302).

From the instant t1, the voltage on the gate of the transistor M2 of device 1041, respectively 1061, decreases, respectively increases, until being equal to the voltage on the gate of the transistor M2 of device 104, respectively 106, at a rate at least partly determined by the value of the capacitor C. Said in other words, from the instant t1, the voltage on the gate of the transistor M2 of device 1041, respectively 1061, decreases, respectively increases, until the device 1041, respectively 1061, is in a steady state.

Thus, when a modification of the voltage between inputs IN1 and IN2 results in an increase of the current Iout, a capacitive load connected to node OUT of the amplifier AMP1 is charged faster than if this load was connected to the node OUT of amplifier AMP.

At an instant t2 posterior to instant t1, a new step of voltage is applied between the inputs IN1 and IN2. In the example of Figure 3, this voltage step corresponds to a decrease of the voltage on the input IN2 while the voltage on the input IN1 is not modified. This results in a decrease of the current I1 and an increase of the current I2.

In the amplifier AMP, the increase of current I2 result in an increase of the voltage across transistor M1 of device 106, thus of the voltage on the gate of transistor M2 of this device 106. Conversely, the decrease of current I1 result in a decrease of the voltage across transistor M1 of device 104, thus of the voltage on the gate of transistor M2 of this device 104. It follows that current I4 increases and current I3 decreases, resulting in a decrease of current Iout of amplifier AMP.

The same occurs in the amplifier AMP1, but, because of resistors RA, the voltage increase on node 1061i is higher than on node 106i, and the voltage decrease on node 1041i is higher than on node 104i. As voltage variations on nodes 1041i and 1061i are transmitted by capacitors C to the gates of transistors M2 of the respective devices 1041 and 1061, the voltage increase on the gate of transistor M2 is higher in device 1061 (see curve 308) than in device 106 (see curve 310), and the voltage decrease on the gate of transistor M2 is higher in device 1041 (see curve 304) than in device 104 (see curve 306). As a result, the decrease of the current Iout is higher in the amplifier AMP1 (see curve 300) than in the amplifier AMP (see curve 302).

From the instant t2, the voltage on the gate of the transistor M2 of device 1061, respectively 1041, decreases, respectively increases, until being equal to the voltage on the gate of the transistor M2 of device 106, respectively 104, at a rate at least partly determined by the value of the capacitor C. Said in other words, from the instant t2, the voltage on the gate of the transistor M2 of device 1061, respectively 1041, decreases, respectively increases, until the device 1061, respectively 1041, is in a steady state.

Thus, when a modification of the voltage between inputs IN1 and IN2 results in a decrease of the current Iout, a capacitive load connected to node OUT of the amplifier AMP1 is discharged faster than if this load was connected to the node OUT of amplifier AMP.

Thus, devices 1041 and 1061 allow to increase the slew rate of the amplifier AMP1 with respect to the one of the amplifier AMP. Devices 1041 and 1061 further allow for increasing the gain of the amplifier AMP1 in the middle frequency band with respect to the one of the amplifier AMP, while leaving the gain in the low frequency band, or, said otherwise, the DC gain, of the amplifier AMP1 unchanged compared to the one of the amplifier AMP.

Further, devices 1041 and 1061 allow to increase the transconductance gain gm during a transient event compare with the one of the amplifier AMP.

Figure 4 illustrates an alternative embodiment of the device 1041 of the amplifier AMP1, being understood that when device 1041 of Figure 4 replaces the device 1041 of Figure 2, the device 1061 of Figure 2 is also replaced by a device 1061 similar or identical to the device 1041 of Figure 4.

More specifically, compared to the device 1041 of Figure 2, device 1041 of Figure 4 further comprises a MOS transistor M2b coupling the drain of transistor M2 to the node 1401o. Transistor M2b has a channel of the same type as the one of transistor M2. Transistors M2 and M2b are series-connected between nodes 108 and 1041o. For example, the source of transistor M2b is connected to the drain of transistor M2, and the drain of transistor M2b is connected to node 1401.

The gate of the transistor M2b is configured to receive a bias voltage Vb, such that transistor M2b operates in saturation.

The transistor M2b allows for increasing the output impedance of the device 1041 of Figure 4 compared to the one of the device 1041 of Figure 2. Increasing the output impedance of the device 1041 allows for increasing the gain of the amplifier AMP1. Transistors M2 and M2b for example constitute a cascode structure.

In one embodiment, as illustrated by Figure 4, the device 1041 further comprises a MOS transistor M1b having a channel of the same type than the one of transistor M2b. Transistor M1b couples the transistor M1 to resistor RA, and has its gate connected to the gate of transistor M2b, or, said in other words, to a node 400 connected to the gate of transistor M2b and configured to receive the voltage Vb. Transistor M1b is series-connected with transistor M1. Transistor M1b is diode-mounted, its gate and its drain being connected with each other. For example, the source of transistor M1b is connected to the drain of transistor M1 and the drain of transistor M1b is connected to node 1041i.

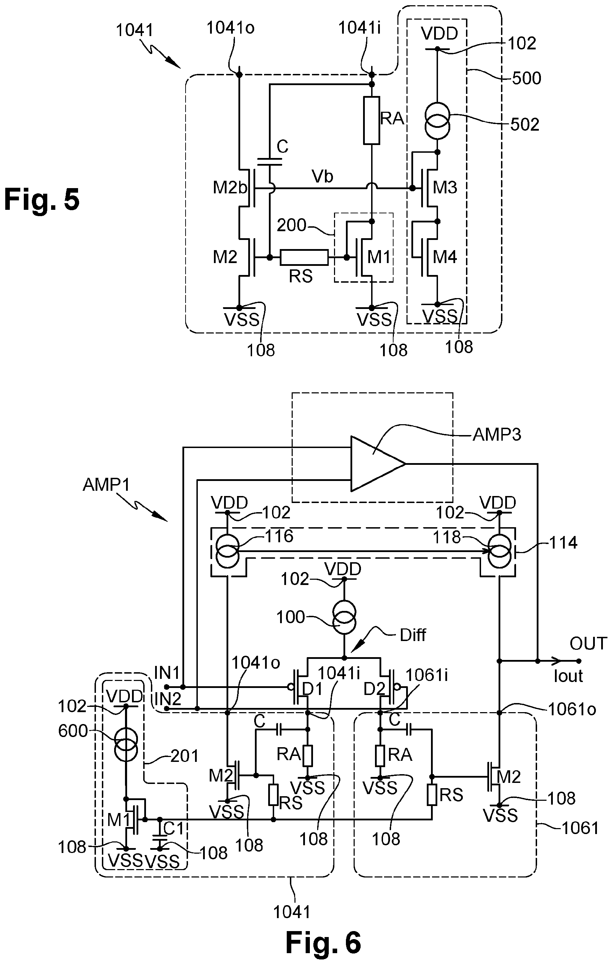

Figure 5 illustrates another alternative embodiment of the device 1041 of the amplifier AMP1, being understood that when device 1041 of Figure 5 replaces the device 1041 of Figure 2, the device 1061 of Figure 2 is also replaced by a device 1061 similar or identical to the device 1041 of Figure 5.

The device 1041 of Figure 5 is similar to the one of Figure 4, and only the differences between these devices are here described.

In order to avoid the voltage drop across the transistor M1b of device 1041 of Figure 4, which involves a higher voltage on node 1041i to ensure that both transistors M1b and M1 operate in saturation in the device 1041 of Figure 4, in the device 1041 of Figure 5, the transistor M1b is omitted and the transistor M1 is connected to resistor RA. In the device 1041 of Figure 5, transistor M1b is replaced by a biasing circuit 500 configured to bias the gate of the transistor M2b. The biasing circuit 500 is configured to provide the biasing voltage Vb to the gate of the transistor M2b.

According to one embodiment, as illustrated by Figure 5, the circuit 500 comprises a current source 502 and two MOS transistors M3 and M4 in series between the current source 502 and the node 108. For example, the source of transistor M3 is connected to the drain of transistor M4, the source of transistor M4 being connected to the node 108.

Transistors M3 and M4 have channels of the same type than the channel of the transistor M2 and M2b. For example, the size of the transistor M3 is identical to the size of transistor M1b of Figure 4, and the size of transistor M4 is identical to the size of the transistor M1.

The current source 502 is connected between node 102 and transistor M3. For example, the current source 502 has a first terminal connected to node 102 and a second terminal connected to the drain of transistor M3. For example, the current source 502 is configured to deliver a current having half the value of the current delivered by the current source 100 of the amplifier AMP1 (Figure 2).

The transistors M3 and M4 are each diode-mounted, the drain of the transistor M3 being connected to the gate of the transistor M3, and the drain of the transistor M4 being connected to the gate of the transistor M4.

The gate of the transistor M3 is connected to the gate of the transistor M2b.

A capacitor (not shown on Figure 5) may be connected between the gate of transistor M2b and the node 108.

Although one specific embodiment of the circuit 500 has been described in relation with Figure 5, those skilled in the art are capable of implementing other biasing circuit 500 providing the voltage Vb on the gate of the transistor M2b, for example with a voltage generator connected to the gate of the transistor M2b and configured to deliver the voltage Vb.

Furthermore, when the devices 1041 and 1061 of the amplifier AMP1 of Figure 2 are implemented as described in relation with Figure 5, these two devices 1041 and 1061 may share the same biasing circuit 500, or, said in other words, the biasing circuit 500 of the device 1401 may also be the biasing circuit of the device 1601.

Figure 6 illustrates a circuit of a transconductance amplifier AMP1 similar to the one of Figure 2, the amplifier AMP1 comprising two devices for copying a current according to yet another alternative embodiment.

More particularly, the amplifier AMP1 of Figure 6 differs from the amplifier AMP1 of Figure 2 by the implementation of its devices 1041 and 1061. Devices 1041 and 1061 of Figure 6 are similar to the ones of Figure 2, and only the differences between these devices are here described.

More particularly, compared to the devices 1041 and 1061 previously described, in each of the devices 1041 and 1061 of Figure 6, the biasing circuit 200 is replaced by a biasing circuit 201.

In the embodiment illustrated by Figure 6, the biasing circuit 201 of device 1041 is also the biasing circuit of the device 1061, or, said in other words, both devices 1041 and 1061 share the same biasing circuit 201. However, in alternative embodiments not illustrated, each device 1041, 1061 has its own dedicated biasing circuit 201.

The biasing circuit 201 of device 1041 is configured to provide a bias voltage to the resistor RS of device 1041, on a terminal of resistor RS opposite to the terminal of the resistor RS connected to the gate of the transistor M2 of device 1041. In the embodiment of Figure 6, the biasing circuit 201 also provides the bias voltage to resistor RS of device 1061, on a terminal of resistor RS opposite to the terminal of the resistor RS connected to the gate of the transistor M2 of device 1061. However, in alternative embodiments (not shown), device 1041 comprises a biasing circuit 201 configured to provide the bias voltage to the resistor RS of the device 1041, and the device 1061 comprises another biasing circuit 201 configured to provide the bias voltage to the resistor RS of the device 1061.

According to one embodiment, the biasing circuit 201 comprises, as the biasing circuit 200, the MOS transistor M1 having a channel of the same type than the one of the MOS transistor M2. Transistor M1 of circuit 201 has its gate and its drain connected with each other, or, said in other words, transistor M1 is diode mounted. The source of transistor M1 is connected to the node 108. The gate of transistor M1 of circuit 201 of device 1041 is connected to the resistor RS of the device 1041, and, more specifically, to the terminal of the resistor RS opposite to the terminal of the resistor RS connected to the gate of transistor M2 of the device 1041. In the embodiment illustrated by Figure 6 where the devices 1041 and 1061 share the same biasing circuit 201, the gate of transistor M1 is also connected to the resistor RS of the device 1061, and, more specifically, to the terminal of the resistor RS opposite to the terminal of the resistor RS connected to the gate of transistor M2 of the device 1061.

Compared to the biasing circuit 200 of device 1041, the biasing circuit 201 of circuit 1041 is not series-connected with the resistor RA of device 1041. More particularly, the transistor M1 of the biasing circuit of the device 1041, respectively 1061, is not series-connected with the resistor RA of this device. Instead, the resistor RA of each device 1041, 1061 is connected to node 108.

The biasing circuit 201 further comprises a current source 600. The current source 600 is series-connected with the transistor M1. The current source 600 couples the drain of the transistor M1 to the node 102. For example, the source 600 has a first terminal connected to the node 102, and a second terminal coupled, for example connected as illustrated by Figure 6, to the drain of transistor M1. For example, the current source 600 is configured to deliver a current having half the value of the current delivered by the current source 100.

A capacitor C1 may be connected between the gate of transistor M1 and the node 108. In alternative examples, capacitor C1 is omitted.

In the embodiment of Figure 6, as transistor M1 is not series-connected with a resistor RA, the voltage drop across the resistor RA due to a modification of the voltage between IN1 and IN2 may be higher, while ensuring that D1 and D2 still operate in saturation for example with lower common-mode voltage. This allows for higher increase or decrease of the voltage on the gate of transistors M2 compared to the previously described devices 1041 and 1061, thus to a faster response to transient events. Further, as all the input transient current is used to increase the gate voltage of the transistor M2, the response to transient events is further increased.

In each device 1041, 1061 of Figure 6, the AC component, or transient component, of the output current of the device is determined by the AC component of the input current of the device. However, the DC component, or steady-state component, of the output current of each device 1041, 1061 of Figure 6 is not determined by the DC value of the input current of the device, but instead by the biasing circuit 201. Said in other word, each device 1041, 1061 of Figure 6 allows for copying a transient or AC current received on its input node to its output node, but the steady-state or DC value of its output current is not determined by the steady state or DC value of its input current, but instead by the biasing circuit 201.

Thus, when the devices 1041 and 1061 of Figure 6 are implemented in the amplifier AMP1, the DC value, or steady state value, of the current Iout is determined by the DC value, or steady state value, of the input voltage between IN1 and IN2 thanks to a supplementary amplifier AMP3.

The biasing amplifier AMP3, for example a transimpedance amplifier, is part of the amplifier AMP1. The amplifier AMP3 as an input connected to the input IN1, a further input connected to the input IN2, and an output connected to the node OUT. The biasing amplifier AMP3 is configured to determine the steady state value, or DC value, of the current Iout based on the steady state value, or DC component, of the voltage between nodes IN1 and IN2.

Although in the example of Figure 6, transistor M2 of each device 1041, 1061 has its drain connected to the output node 1041o, respectively 1061o, of the device, in alternative examples (not shown), the device 1041, respectively 1061, may further comprises the transistor M2b, as previously described in relation with Figure 5.

In such a case, in each device 1041, 1061, transistor M2 is coupled to the output node of the device by the transistor M2b, as previously described in relation with Figure 5. Further, each of the devices 1041 and 1061 may comprises its own circuit 500 for biasing the gate of its transistor M2b, or, alternatively, only one circuit 500 is shared between the two device 1041 and 1061 and biases the gate of the transistors M2b of these two devices 1041 and 1061.

Alternatively, when transistor M2 of devices 1041, respectively 1061, is coupled to the node 1041o, respectively 1061o, by a corresponding transistor M2b, instead of providing a biasing circuit 500, the biasing circuit 201 of the device further comprises the transistor M3 described in relation with Figure 5 which is then series-connected with the transistor M1 and the current source 600. Transistor M3 is diode-mounted and has its gate connected to the gate of transistor M2b. In this alternative, the biasing circuit 201 allows for also biasing the gate of the transistor M2b. Each of the devices 1041 and 1061 may comprise its own circuit 201 for biasing the gates of its two transistors M2 and M2b, or the devices 1041 and 1061 may share only one circuit 201 for biasing their transistors M2 and M2b.

In all the above described embodiments, the amplifier AMP1 is preferably used as a transimpedance amplifier. However, the amplifier AMP1 may also be used as a comparator. In this last case, when the transistors M2 of the devices 1041 and 1061 are each biased by a corresponding circuit 200 comprising the transistor M1, an hysteresis functionality may be implemented, for example, by adding two supplementary MOS transistors having the same channel type as the one of the transistor M1, a first one of these two supplementary transistors having a source coupled, preferably connected, to node 108, a gate connected to the gate of the transistor M2 of device 1041, and a drain coupled, preferably connected, to node 1061i, a second one of these two supplementary transistors having a source coupled, preferably connected, to node 108, a gate connected to the gate of the transistor M2 of device 1061, and a drain coupled, preferably connected, to node 1041i.

Furthermore, although the device 1041 and 1061 have been described as being part of the amplifier AMP1, each of the device 1041 and 1061 may be used for implementing a current mirror in circuits others than a transconductance amplifier, in particular when the gate of transistor M2 of the device is biased by a circuit 200.

Furthermore, although the circuit 114 of the amplifier AMP1 may be a known current mirror, it could also be implemented by a device similar to device 1041 previously described wherein the node 108 is replaced by node 102 and the transistors of the device are PMOS transistors.

Various embodiments and variants have been described. Those skilled in the art will understand that certain features of these embodiments can be combined and other variants will readily occur to those skilled in the art. In particular, in the example described above, the voltage VDD on node 102 is higher than voltage VSS on node 108. In other examples (not shown), the voltage VDD on node 102 is lower than voltage VSS on node 108, and the channel-type of all the described transistors is inverted, the P-type channel transistors becoming N-type channel transistors and the N-type channel transistors becoming P-type channel transistors. More generally, when voltages on nodes 1041i and 1041o, respectively 1061i and 1061o, of device 1041, respectively 1061, are lower than voltage VSS on node 108, the transistors of the device 1041, respectively 1061, are PMOS transistors instead of NMOS transistors as in the examples previously described.

Finally, the practical implementation of the embodiments and variants described herein is within the capabilities of those skilled in the art based on the functional description provided hereinabove. In particular, the values of the currents delivered by the current sources 502 and 600 are not limited to the examples given above, and those skilled in the art are capable of implementing the biasing circuits 201 and 500 with other current values.

## Claims

1. A device (1041; 1061) comprising:
an input node (1041i; 1061i) configured to receive a first current (I1; I2);
an output node (1041o; 1061o) configured to provide a second current (I3; I4) determined by the first current;
a first resistor (RA) having a first terminal connected to the input node and a second terminal coupled to a first node (108) configured to receive a first supply voltage (VSS);
a first MOS transistor (M2) having a source connected to the first node (108) and a drain coupled to the output node (1041o; 1061o) of the device;
a second resistor (RS) having a first terminal connected to a gate of the first MOS transistor (M2);
a biasing circuit (200; 201) configured to provide a biasing voltage on a second terminal of the second resistor (RS); and
a first capacitor (C) connected between the input node (1041i; 1061i) and the gate of the first MOS transistor (M2) .

2. The device of claim 1, wherein the drain of the first transistor (M2) is connected to the output node (1041o, 1061o).

3. The device of claim 1, further comprising a second MOS transistor (M2b) having a channel of the same type as the channel of the first MOS transistor (M2), the second MOS transistor (M2b) coupling the drain of the first MOS transistor (M2) to the output node (1041o, 1061o) and being series-connected with the first MOS transistor (M2).

4. The device of any of claims 1 to 3, wherein the biasing circuit (200; 201) comprises a third MOS transistor (M1) having a channel of the same type as the channel of the first MOS transistor (M2), the third MOS transistor (M1) having a drain and a gate connected with each other, and a source connected to the first node (108), the gate of the third MOS transistor (M1) being connected to the second terminal of the second resistor (RS).

5. The device of claim 4, wherein the third MOS transistor (M1) is series-connected with the first resistor (RA).

6. The device of claim 4 or 5, wherein the third MOS transistor (M1) has its drain connected to the second terminal of the first resistor (RA).

7. The device of claim 4, wherein the bias circuit (201) further comprises a current source (600) series-connected with the third MOS transistor (M1).

8. The device of claim 7, wherein the second terminal of the first resistor (RA) is connected to the first node (108).

9. The device of claim 7 or 8, wherein the bias circuit (201) further comprises a second capacitor (C1) connected between the gate of the third MOS transistor (M1) and the first node (108) .

10. An amplifier (AMP1) comprising:
a first device (1041) according to any of claims 1 to 6;
a second device (1061) according to any of claim 1 to 6, the output node (1061o) of the second device (1061) being coupled, preferably connected, to an output node (OUT) of the amplifier (AMP1);
a differential pair (Diff) comprising:
- a first MOS transistor (D1) having a first conduction node coupled, preferably connected, to the input node (1041i) of the first device (1041), and a gate connected to a first input (IN1) of the amplifier (AMP1), and
- a second MOS transistor (D2) having a channel of the same type as the channel of the first MOS transistor (D1) of the differential pair (Diff), a first conduction node coupled, preferably connected, to the input node (1061i) of the second device (1061), and a gate connected to a second input (IN2) of the amplifier (AMP1); and
a current source (100) for biasing the differential pair (Diff), the current source having a terminal coupled, preferably connected, to a second conduction terminal of each of the first and second MOS transistors (D1, D2) of the differential pair (Diff) and another terminal coupled, preferably connected, to a node (102) configured to receive a second supply potential (VDD).

11. An amplifier comprising:
a first device (1041) according to any of claims 7 to 9;
a second device (1061) according to any of claims 7 to 9, the output node (1061o) of the second device (1061) being coupled, preferably connected, to an output node (OUT) of the amplifier (AMP1);
a differential pair (Diff) comprising:
- a first MOS transistor (D1) having a first conduction node coupled, preferably connected, to the input node (1041i) of the first device (1041), and a gate connected to a first input (IN1) of the amplifier (AMP1), and
- a second MOS transistor (D2) having a channel of the same type as the channel of the first MOS transistor (D1) of the differential pair (Diff), a first conduction node coupled, preferably connected, to the input node (1061i) of the second device (1061), and a gate connected to a second input (IN2) of the amplifier (AMP1); and
a current source (100) for biasing the differential pair (Diff), the current source having a terminal coupled, preferably connected, to a second conduction terminal of each of the first and second MOS transistors (D1, D2) of the differential pair (Diff) and another terminal coupled, preferably connected, to a node (102) configured to receive a second supply potential (VDD).

12. The amplifier of claim 11, further comprising a supplementary amplifier (AMP3) having a first input coupled, preferably connected, to the gate of the first MOS transistor (D1) of the differential pair (Diff), a second input coupled, preferably connected, to the gate of the second transistor (D2) of the differential pair (Diff), and an output coupled, preferably connected, to the output node (OUT) of the amplifier (AMP1).

13. The amplifier according to claim 11 or 12, wherein the biasing circuit (201) of the first device (1041) is also the biasing circuit of the second device (1061).

14. The amplifier of any of claim 10 to 13, further comprising a first circuit (114) coupled to the output node (1041o) of the first device (1041), the output node (OUT) of the amplifier (AMP1) and the node (102) configured to receive the second supply potential (VDD), wherein the first circuit (114) is configured to receive the second current (I3) of the first device (1041) and to provide a current (I5) proportional to this second current (I3) to the output node (OUT) of the amplifier (AMP).

15. The amplifier according to any of claim 10 to 14, adapted to implement a transimpedance function between its inputs (IN1, IN2) and its output node (OUT).
